## Europäisches Patentamt
## European Patent Office
## Office européen des brevets

(19)

(11) Veröffentlichungsnummer: **0 089 527**
**A2**

(12) # EUROPÄISCHE PATENTANMELDUNG

(21) Anmeldenummer: 83102111.8

(22) Anmeldetag: 04.03.83

(51) Int. Cl.³: **H 01 L 27/08**

(30) Priorität: 20.03.82 DE 3210353

(43) Veröffentlichungstag der Anmeldung:
28.09.83 Patentblatt 83/39

(84) Benannte Vertragsstaaten:
DE FR GB NL SE

(71) Anmelder: ROBERT BOSCH GMBH
Postfach 50
D-7000 Stuttgart 1(DE)

(72) Erfinder: Hartmut, Michel, Dipl.-Ing.
Aaranstrasse 56
D-7410 Reutlingen(DE)

(54) **Monolithisch integrierte Darlingtonschaltung.**

(57) Es wird eine monolithisch integrierte, aus einem vertikalen MOSFET-Treibertransistor (TT) und einem vertikalen Bipolar-Leistungstransistor (LT) bestehende Darlingtonschaltung vorgeschlagen, bei der die Drainzone des MOSFET-Treibertransistors (TT) und die Kollektorzone des Bipolar-Leistungstransistors (LT) durch ein gemeinsames Halbleitersubstrat (10) gebildet werden. Die Source-Elektrode (18) des MOSFET-Treibertransistors (TT) ist dabei an die Basiselektrode (19) des Bipolar-Leistungstransistors (LT), der zugleich den Endstufentransistor (ET) der Darlingtonschaltung bildet, angeschlossen. Der MOSFET-Treibertransistor (TT) ist asymmetrisch ausgebildet und enthält nur eine einzige Kanalzone (17) und eine einzige Sorce-Metallisierung (18). Die Kanalzone (17) und die oberhalb dieser Kanalzone (17) angeordnete Gateelektrode (21) des MOSFET-Treibertransistors (TT) ist dem Bipolar-Leistungstransistors (LT) zugewandt, während die Source-Metallisierung (18) des MOSFET-Treibertransistors (TT) dem Bipolar-Leistungstransistor (LT) abgewandt ist. Im Bipolar-Leistungstransistor (LT) ist ferner die zur Zuführung seines Basisstroms dienende Basismetallisierung (19) nur in demjenigen Teil seiner Basiswanne (12) angebracht, dem der MOSFET-Treibertransistor (TT) unmittelbar benachbart ist.

EP 0 089 527 A2

R. 17737
18.2.1982 Fb/Le

0089527

ROBERT BOSCH GMBH, 7000 STUTTGART 1

Monolithisch integrierte Darlingtonschaltung

Stand der Technik

Die Erfindung betrifft eine monolithisch integrierte
Darlingtonschaltung nach der im wesentlichen übereinstimmenden Gattung der Ansprüche 1 bis 5.

Aus der Zeitschrift Markt & Technik Nr. 35 vom 28. August
1981, Seite 18, ist bereits eine Darlingtonschaltung
dieser Art bekannt. Bild 1 dieser Veröffentlichung zeigt
den strukturellen Aufbau, Bild 2 das Ersatzschaltbild
dieser bekannten Darlingtonschaltung. Die beiden Transistoren sind dabei im lay-out unmittelbar nebeneinander
angeordnet, weil der Bipolar-Leistungstransistor zugleich
den Endstufentransistor der gesamten Darlingtonschaltung
bildet, eine möglicherweise noch vorzusehende Bipolar-
Zwischenstufe zwischen der MOSFET-Eingangsstufe und dem
Bipolar-Endstufentransistor also nicht vorhanden ist. Der
MOSFET-Treibertransistor ist dabei als n-Kanaltransistor,
der Bipolar-Endstufentransistor als npn-Transistor ausge-

...

bildet. Gemäß Bild 1 dieser Veröffentlichung ist der
Bipolar-Endstufentransistor symmetrisch zu seiner
zentral angeordneten Emitterzone ausgebildet. Seine
Basiszone trägt - in der Schnittdarstellung nach Bild 1 -
zu beiden Seiten der Emitterzone eine Basismetallisierung,
wobei diese beiden Metallisierungen gemeinsam mit der
Source-Elektrode des MOSFET-Treibertransistors verbunden
sind. Der MOSFET-Treibertransistor besitzt eine zentral
angeordnete Gateelektrode, unterhalb der symmetrisch zum
Gateelektrodenanschluß zwei Kanalzonen angeordnet sind,
die Bestandteil zweier Körperzonen sind, die sich zu
beiden Seiten von der Gateelektrode hinweg erstrecken
und in die jeweils eine Source-Zone eindiffundiert ist.
Dementsprechend sind auch zwei Source-Zonen und zwei
Source-Metallisierungen vorhanden, die sich zu beiden
Seiten der Gateelelektrode befinden und je einer der
beiden Kanalzonen zugeordnet sind. Die Zusammenführung
dieser beiden Source-Metallisierungen bildet die Source-
Elektrode des MOSFET-Treibertransistors, die mit der
Basiselektrode des Bipolar-Endstufentransistors verbunden ist. Diese Darlingtonschaltung hat den Nachteil, daß in ihr im on-Zustand der Bahnwiderstand der
Drainzone des MOSFET-Treibertransistors verhältnismäßig
hoch ist und deshalb der MOSFET-Treibertransistor sehr
großflächig ausgeführt werden muß.

Vertikale MOSFET-Transistoren, die in ähnlicher Weise
symmetrisch zur Gateelektrode ausgebildet sind wie
der soeben beschriebene MOSFET-Treibertransistor der
bekannten MOSFET-Bipolar-Darlingtonschaltung, sind auch
aus der DE-OS 31 10 230 und aus der DE-OS 31 05 693 bekannt.

. . .

Aus der Zeitschrift Elektronik Band 23 (1981), Seite 72,
ist es außerdem ebenfalls bekannt, einen Darlington-Transistor aus einem MOSFET-Treibertransistor und einem Bipolar-
Leistungstransistor zu bilden.

Vorteile der Erfindung

Die erfindungsgemäße Darlingtonschaltung mit den kennzeichnenden Merkmalen eines der Ansprüche 1 bis 7 hat
gegenüber der aus der Zeitschrift Markt & Technik
Nr. 35 vom 28. August 1981, Seite 18 bekannten Darlington-
Schaltung den Vorteil, daß die Kanalzone des MOSFET-
Treibertransistors sehr nahe an die Basismetallisierung
des Bipolar-Endstufentransistors der Darlingtonschaltung
und damit sehr nahe an die injizierende Kante des Emitters
dieses Endstufentransistors gerückt ist, wodurch für den
MOSFET-Treibertransistor im on-Zustand der Bahnwiderstand
der Drainzone drastisch reduziert wird. Besonders wirkungsvolle Weiterbildungen des Gegenstandes nach den Ansprüchen
5 bis 7 enthalten die Ansprüche 8 und 9. Diese Ansprüche
bewirken durch ihre Kombinationswirkung eine besonders
starke Erniedrigung des genannten Bahnwiderstandes besonders dann, wenn eine sehr große Anzahl von Streifen verwendet wird.

Durch die Maßnahmen des Anspruchs 5, gegebenenfalls in Verbindung mit den Maßnahmen des Anspruchs 7, wird gleichzeitig eine gleichmäßige thermische Belastung des Kristalls
beim Betrieb mit hoher Verlustleistung erreicht.

Zeichnung

Ausführungsbeispiele der erfindungsgemäßen Darlingtonschaltung sind in der Zeichnung dargestellt und in der
nachfolgenden Beschreibung näher erläutert. Es zeigen:

...

- 4 -

Figur 1 eine bekannte, aus einem MOSFET-
Treibertransistor und einem Bipolar-Leistungstransistor bestehende Darlingtonschaltung,
bei der der Bipolar-Leistungstransistor einstufig ausgebildet ist,

Figur 2 die Schaltung nach Figur 1 mit einem
zweistufigen Bipolar-Leistungstransistor, bei
dem die beiden Stufen dieses Transistors wieder
in Darlingtonschaltung miteinander verbunden sind,

Figur 3 einen Schnitt bzw. einen Teilschnitt durch
das lay-out eines ersten Ausführungsbeispiels
einer Darlingtonschaltung gemäß der Erfindung,
die aus einem einzigen MOSFET-Treibertransistor
und einem ein- oder mehrstufigen Bipolar-
Leistungstransistor besteht, von dem aber nur der
Endstufentransistor dargestellt ist,

Figur 4 einen Teilschnitt aus dem lay-out eines
zweiten Ausführungsbeispiels einer Darlingtonschaltung gemäß der Erfindung mit einem einstufigen Bipolar-Leistungstransistor, bei dem
der MOSFET-Treibertransistor und die Bipolar-
Endstufe jeweils in eine Vielzahl streifenförmig
ausgebildeter Teilelemente unterteilt ist, wobei die Teilelemente dieser beiden Stufen abwechselnd aufeinander folgen,

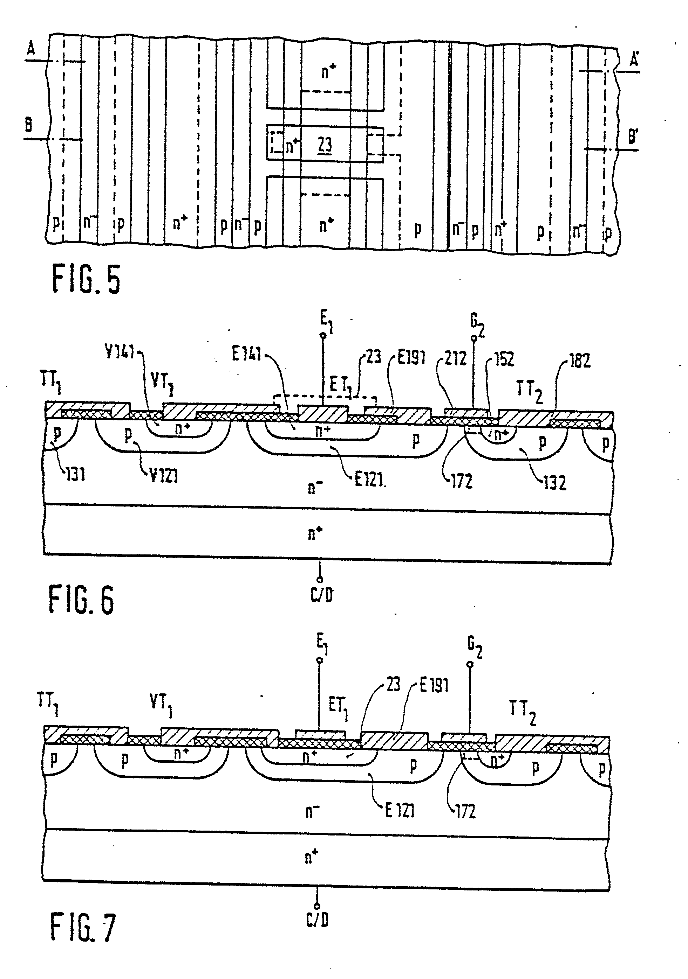

Figur 5 eine teilweise Draufsicht auf das lay-out
eines dritten Ausführungsbeispiels einer Darlingtonschaltung gemäß Erfindung mit einem zweistufigen
Bipolar-Leistungstransistor und einem einstufigen
MOSFET-Treibertransistor, bei dem diese drei

. . .

Stufen in Darlingtonschaltung
miteinander verbunden sind und bei dem jede
Stufe dieser dreistufigen Anordnung in eine
Vielzahl streifenförmig ausgebildeter Teilelemente unterteilt ist, wobei die Teilelemente
dieser drei Stufen in der Reihenfolge aufeinander folgen, in der die Stufen im Ersatzschaltbild hintereinander angeordnet sind, und wobei
diese Folge sich periodisch entsprechend der
Anzahl der Teilelemente wiederholt,

Figur 6 einen Schnitt nach der Linie A-A'
der Figur 5,

Figur 7 einen Schnitt nach der Linie B-B'
der Figur 5.

Beschreibung der Ausführungsbeispiele

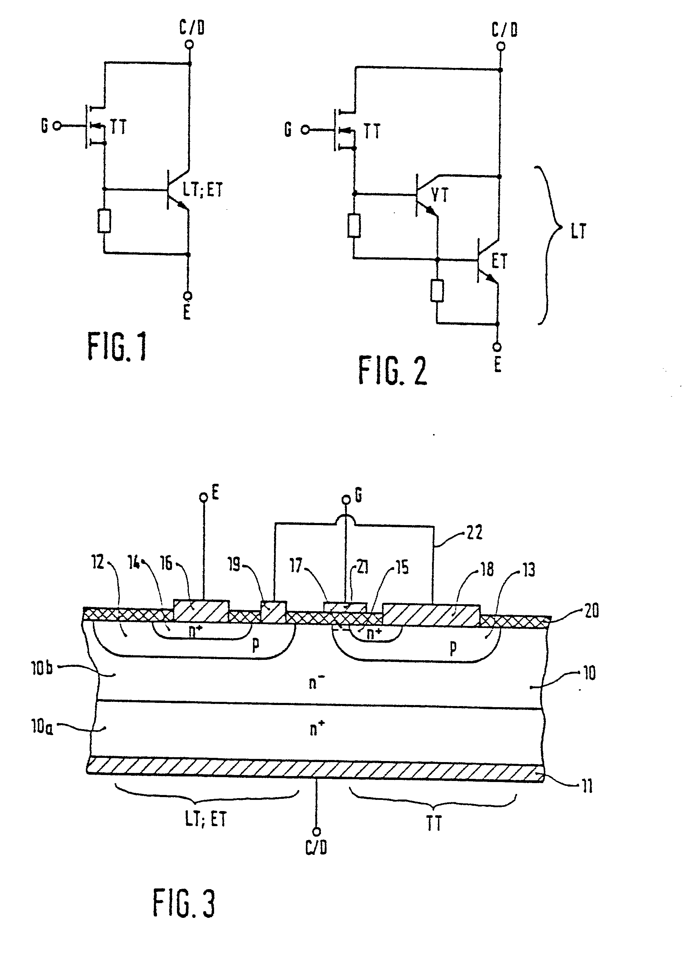

Figur 1 zeigt das elektrische Schaltbild einer Darlingtonschaltung, die aus einem MOSFET-Treibertransistor TT und
einem Bipolar-Leistungstransistor LT besteht, der zugleich
den Endstufentransistor ET der Darlingtonschaltung bildet.
Der Transistor TT ist als n-Kanaltransistor, der Transistor
LT als npn-Transistor ausgebildet. Der Kollektor des Transistors LT ist an die Drainelektrode des Transistors TT
angeschlossen, während die Source-Elektrode des Transistors TT an die Basis des Transistors LT angeschlossen
ist. Die Basis-Emitter-Strecke des Transistors LT ist
durch einen ohmschen Widerstand überbrückt.

. . .

Figur 2 zeigt das elektrische Schaltbild einer aus einem MOSFET-Treibertransistor TT und einem Bipolar-Leistungstransistor LT bestehenden Darlingtonschaltung, bei der der Bipolar-Leistungstransistor LT aus einem Vorstufentransistor VT und einem Endstufentransistor ET besteht. Der Transistor TT ist als n-Kanaltransistor, die Transistoren VT und ET als npn-Transistoren ausgebildet. Die Kollektoren der Transistoren VT und ET sind an die Drainelektrode des Transistors TT angeschlossen. Die Source-Elektrode des Transistors TT ist an die Basis des Vorstufentransistors VT und der Emitter des Vorstufentransistors VT an die Basis des Endstufentransistors ET angeschlossen. Die Basis-Emitter-Strecken der Transistoren VT und ET sind durch je einen ohmschen Widerstand überbrückt.

Figur 3 zeigt ein erfindungsgemäßes lay-out der Darlington-Schaltung nach Figur 1, das auch als Ausschnitt aus einem erfindungsgemäßen lay-out der Schaltung nach Figur 2 aufgefaßt werden kann. In dem gemeinsamen Halbleitersubstrat 10 ist sowohl der vertikale MOSFET-Treibertransistor TT als auch der Bipolar-Endstufentransistor LT bzw. ET untergebracht. Das Halbleitersubstrat 10 bildet dabei sowohl die Drainzone des Transistors TT als auch die Kollektorzone des Transistors LT bzw. ET. Das Substrat 10 ist an seiner Unterseite ganzflächig mit einer Metallisierung 11 versehen, die die gemeinsame Elektrode der Kollektor- bzw. Drainzone der beiden Transistoren bildet. Das Substrat 10 besitzt einen unteren, $n^+$-leitenden Bereich 10a und einen oberen, $n^-$-leitenden Bereich 10b. In den oberen Bereich 10b des Substrats 10 ist eine Zone 12 und eine Zone 13 mit p-Leitfähigkeit eindiffundiert. In die Zone 12 ist eine $n^+$-leitfähige Zone 14 und in die Zone 13 eine $n^+$-leitfähige

...

Zone 15 eindiffundiert. Die Zone 12 bildet die Basiszone,
die Zone 14 die Emitterzone des Bipolar-Endstufentransistors ET, dessen Emittermetallisierung mit 16 und dessen
Emitteranschluß symbolisch mit E bezeichnet ist. Die
Zone 13 bildet die Körperzone und die Zone 15 die Source-
Zone des MOSFET-Treibertransistors TT. Auf der Oberseite des Halbleitersubstrats 10 wird die Source-Zone 15
und die Körperzone 13 in einem von der Kanalzone 17 abgewandten und von dieser entfernten Bereich mit Hilfe der
Source-Metallisierung 18 kontaktiert. Die Metallisierung 18
schließt also die Zonen 13 und 15 an der Oberfläche des
Substrats 10 kurz. Die Basismetallisierung des Endstufentransistors ET ist mit 19 bezeichnet. An den Bereichen
außerhalb der Metallisierungen 16, 19, 18 ist die Oberseite des Halbleitersubstrats 10 mit einer Siliziumdioxidschicht 20 bedeckt, die im Bereich oberhalb der Kanalzone
17 als Gateoxid des MOSFET-Treibertransistors TT ausgebildet und dort mit der Gatemetallisierung 21 bedeckt
ist, die mit dem Gateanschluß G des MOSFET-Treibertransistors TT verbunden ist. Die elektrisch leitende Verbindung zwischen der Basismetallisierung 19 des Bipolar-
Endstufentransistors ET und der Source-Metallisierung 18
des MOSFET-Treibertransistors TT ist bei 22 angedeutet.

Erfindungsgemäß nimmt die Basiszone 12 des Bipolar-
Leistungstransistors LT an derjenigen Seite dieses
Transistors, die dem MOSFET-Treibertransistor TT zugewandt ist, einen derart breiten Raum ein, daß
an dieser Seite der Zone 12 die Basismetallisierung 19
angebracht werden kann. Darüber hinaus hat erfindungsgemäß der MOSFET-Treibertransistor TT nur eine einzige
Kanalzone 17, und diese ist unmittelbar angrenzend an

...

die Basismetallisierung 19 des Bipolar-Endstufentransistors LT gelegt, wobei der Abstand zwischen der Metallisierung 19 und der Kanalzone 17 so gering wie möglich bemessen ist. Dadurch wird erreicht, daß für den MOSFET-Treibertransistor TT im on-Zustand der Bahnwiderstand der Drainzone 10 drastisch reduziert wird.

Es versteht sich, daß bei diesem Ausführungsbeispiel nach Figur 3 der Bipolar-Leistungstransistor auch aus einer mehrstufigen Darlingtonschaltung bestehen kann. In diesem Falle ist es aber besonders vorteilhaft, wenn der durch die Zonen 10, 12, 14 gebildete Bipolar-Transistor, der im lay-out unmittelbar neben dem MOSFET-Treibertransistor TT angeordnet ist, der Endstufentransistor ET dieser Darlingtonschaltung ist. Dadurch wird der Bahnwiderstand der Drainzone des MOSFET-Treibertransistors TT im on-Zustand besonders stark reduziert. Bei einer solchen Darlingtonschaltung, die aus einem MOSFET-Treibertransistor und aus einem zwei- oder mehrstufigen Bipolar-Leistungstransistor besteht, müssen dann die Bipolar-Vorstufen, die in Figur 2 summarisch mit VT bezeichnet sind, außerhalb der in Figur 3 gezeichneten, aus der ersten und der letzten Stufe bestehenden Anordnung TT, ET untergebracht werden.

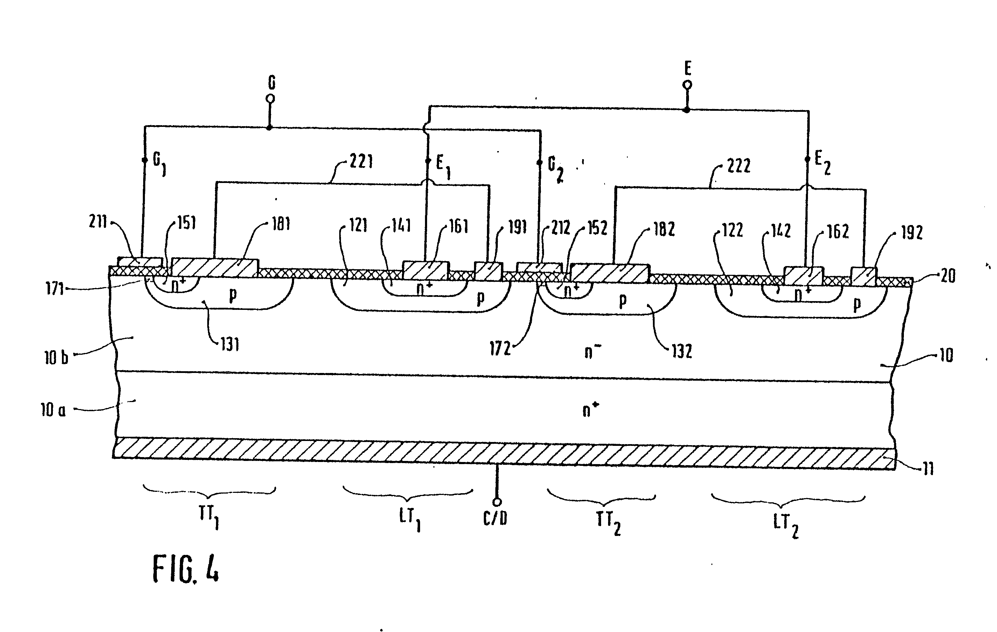

Figur 4 zeigt einen Teilschnitt aus dem lay-out eines weiteren Ausführungsbeispiels einer Darlingtonschaltung gemäß der Erfindung mit einem einstufigen MOSFET-Treibertransistor TT und einem einstufigen Bipolar-Leistungstransistor LT, der zugleich den Endstufentransistor ET der gesamten zweistufigen Darlingtonschaltung bildet.

. . .

Bei diesem Ausführungsbeispiel ist der MOSFET-Treibertransistor TT und der Bipolar-Leistungstransistor LT jeweils in eine Vielzahl n streifenförmig ausgebildeter Teilelemente $TT_i$, $LT_i$ unterteilt. Die Elektroden $G_i$ der Teilelemente $TT_i$ sind dabei untereinander zur Bildung eines gemeinsamen äußeren Gateanschlusses G verbunden, während die Elektroden $E_i$ der Teilelemente $LT_i$ unter-einander zur Bildung eines gemeinsamen äußeren Emitteranschlusses E verbunden sind. Diese durch Fig. 1 vorgeschriebenen Verbindungen sind in Fig. 4 aus Gründen der Übersichtlichkeit nur schaltbildmäßig als "Verbindungsleitungen" dargestellt. Auch beim Ausführungsbeispiel nach den Figuren 5 bis 7 sind zur Bildung eines gemeinsamen äußeren Gateanschlusses G und zur Bildung eines gemeinsamen äußeren Emitteranschlusses E (Fig. 2) die entsprechenden Elektroden $G_i$ und $E_i$ jeweils untereinander zu verbinden. Diese Verbindungen sind aus Gründen der Übersichtlichkeit in den Figuren 5 bis 7 jedoch nicht gezeichnet. Die streifenförmig ausgebildeten Teil-elemente $TT_i$, $LT_i$ sind in dem Halbleitersubstrat 10 gemäß Figur 4 periodisch derart aneinandergereiht, daß jeweils auf ein Teilelement $TT_i$ des MOSFET-Treibertran-sistors TT ein Teilelement $LT_i$ des Bipolar-Leistungs-transistors LT folgt und so fort. Von diesen so peri-odisch aufeinanderfolgenden Teilelementen $TT_i$, $LT_i$ sind in Figur 4 nur zwei herausgegriffene, aufeinanderfolgende Paare $TT_1$, $LT_1$; $TT_2$, $LT_2$ dieser paarweise aufeinander-folgenden Teilelemente der beiden Transistoren TT, LT dargestellt. Es sind dieselben Bezeichnungen wie in Figur 3 verwendet, jedoch sind die dort verwendeten zweistelligen Ziffern zu dreistelligen Ziffern ergänzt, indem bei jedem Teilelement des ersten Paares (i = 1) die Ziffer 1 und bei jedem Teilelement des zweiten Paares (i = 2) die Ziffer 2 der jeweils in Figur 3 verwendeten Ziffer nachgestellt wurde.

Die Anordnung nach Figur 4 unterscheidet sich von
der Anordnung nach Figur 3 dadurch, daß innerhalb jeder
Periode i der streifenförmigen Teilelemente $TT_i$, $LT_i$ die
Stufenfolge des Ersatzschaltbilds nach Figur 1 beibehalten ist und daß die Herabsetzung des Bahnwiderstandes
der Drainzone des MOSFET-Treibertransistors TT im on-
Zustand dadurch zustandekommt, daß das MOSFET-Teilelement
$TT_i$ einer Periode i sich immer an das Bipolar-Teilelement
$LT_{i-1}$ der vorausgehenden Periode i - 1 anschließt. Beim Ausführungsbeispiel nach Figur 4 ist aber zusätzlich noch
die Basismetallisierung des Bipolar-Teilelements $LT_i$
einer Periode i immer unmittelbar neben die Kanalzone
des MOSFET-Teilelements $TT_{i+1}$ der darauffolgenden
Periode i + 1 gerückt, beispielsweise die Metallisierung
191 neben die Kanalzone 172.

Die Figuren 5 bis 7 zeigen am Beispiel der dreistufigen
Darlingtonschaltung, wie sie in Figur 2 im Ersatzschaltbild dargestellt ist, eine Möglichkeit der praktischen
Realisierung des in Figur 4 für eine zweistufige Darlingtonschaltung nur schematisch dargestellten Prinzips. Beim
Ausführungsbeispiel nach den Figuren 5 bis 7 ist die
Streifenfolge $TT_i$, $LT_i$ der Figur 4 durch die Streifenfolge $TT_i$, $VT_i$, $ET_i$ ersetzt. Die Streifenfolge innerhalb
jeder Periode i im gesamten lay-out entspricht also der
Folge der Stufen TT, VT, ET aus dem Ersatzschaltbild nach
Figur 2. Dies hat zur Folge, daß das MOSFET-Teilelement
$TT_i$ einer Periode i sich immer an das Endstufen-Teilelement
$ET_{i-1}$ der vorausgehenden Periode i - 1 anschließt.
Analog zum Ausführungsbeispiel nach Figur 4 ist zusätzlich

...

noch die Basismetallisierung $E19_i$ des Endstufen-Teil-elements $ET_i$ jeder Periode i unmittelbar neben die Kanalzone $17_{i+1}$ des MOSFET-Teilelements $TT_{i+1}$ der darauffolgenden Periode i + 1 gerückt, beispielsweise die Metallisierung E191 neben die Kanalzone 172. Es sind also auch hier wie beim Ausführungsbeispiel nach Figur 4 die erfindungsgemäßen Maßnahmen, die schon beim Ausführungsbeispiel nach Figur 3 an dem Transistorpaar ET, TT als ungeteilte Einzeltransistoren Anwendung gefunden haben, bei jedem entsprechenden Paar von Teilelementen erfüllt. Der Unterschied ist nur, daß die Paare von Teilelementen, an denen diese Maßnahmen verwirklicht sind, sich aus Einzelelementen $ET_i$, $TT_{i+1}$ zusammensetzen, die zwar ein-ander unmittelbar benachbart sind, jedoch aufeinanderfolgenden Perioden i und i + 1 des Gesamtstreifensystems angehören. Auf diese Weise wird die gewünschte Ankoppelung der ersten an die letzte Stufe erreicht, ohne daß die geometrische Reihenfolge der Teilelemente entsprechend dem Ersatzschaltbild der Gesamtschaltung innerhalb jeder Periode gestört wird. Dies gilt in gleicher Weise sowohl für das Ausführungsbeispiel nach Figur 4 wie auch für das Ausführungsbeispiel nach den Figuren 5 bis 7.

Um eine Mehrlagenverdrahtung zu verhindern, ist beim Ausführungsbeispiel nach den Figuren 5 bis 7 die normale Streifenfolge im Bereich der Streifen $ET_i$, die dem End-stufentransistor ET angehören, stellenweise unterbrochen (Schnitt B-B' und Figur 7). Der hierdurch geschaffene Platz wird dazu benützt, um die elektrisch leitende Ver-

...

bindung zwischen dem Emitter $V14_i$ des Vorstufentransistors $VT_i$ und der Basis $E12_i$ des Endstufentransistors $ET_i$ mit Hilfe eines $n^+$-Divers 23 ohne Mehrlagenmetallisierung so herzustellen, daß diese Verbindung bis zu der Basismetallisierung $E19_i$ reicht, die unmittelbar an die Kanalzone $17_{i+1}$ des MOSFET-Treibertransistorstreifens $TT_{i+1}$ der darauffolgenden Periode i + 1 angrenzt. Der $n^+$-Diver 23 ist dabei in an sich bekannter Weise in eine ihn umgebende p-leitende Zone eindiffundiert, die ihn gegen das Substrat 10 isoliert, und im vorliegenden Falle gleichzeitig die Basiszone $E12_i$ des Streifens $ET_i$ bildet. In Figur 7 ist diese Maßnahme am Beispiel der Streifen $VT_1$, $ET_1$, $TT_2$ gezeigt. Der $n^+$-Diver 23 ist hier in die Basiswanne E121 des Streifens $ET_1$ eingebettet und führt zu der Basismetallisierung E191 des Streifens $ET_1$, die unmittelbar an die Kanalzone 172 des Streifens $TT_2$ angrenzt.

Abweichend von den Darstellungen der Fig. 3 bis Fig. 7 können die Gate-Leiterbahnen auch aus dotiertem Poly-Silizium bestehen und vollständig in eine elektrisch isolierende Glas- oder Oxidschicht eingebettet sein. Eine Überlappung von anderen Leiterbahnen wäre dadurch möglich.

R.
18.2.1982 Fb/Le

ROBERT BOSCH GMBH, 7000 STUTTGART 1

Ansprüche

1. Monolithisch integrierte, aus einem vertikalen MOSFET-
Treibertransistor (TT) und einem vertikalen Bipolar-
Leistungstransistor (LT) bestehende Darlingtonschaltung,
bei der die Drainzone des MOSFET-Treibertransistors (TT)
und die Kollektorzone des Bipolar-Leistungstransistors
(LT) durch ein gemeinsames Halbleitersubstrat (10) gebildet werden, die Source-Elektrode (18) des MOSFET-
Treibertransistors (TT) an die Basiselektrode (19) des
Bipolar-Leistungstransistors (LT) angeschlossen ist, der
zugleich den Endstufentransistor (ET) der Darlingtonschaltung bildet, wobei der MOSFET-Treibertransistor (TT)
und der Bipolar-Leistungstransistor (LT) im lay-out
nebeneinander angeordnet sind, dadurch gekennzeichnet,
daß der MOSFET-Treibertransistor (TT) eine einzige Kanalzone (17) und eine einzige Source-Metallisierung (18)
enthält, daß die Kanalzone (17) und die oberhalb dieser
Kanalzone (17) angeordnete Gateelektrode (21) des MOSFET-
Treibertransistors (TT) dem Bipolar-Leistungstransistor
(LT) zugewandt und die Source-Metallisierung (18) des
MOSFET-Treibertransistors (TT) dem Bipolar-Leistungstransistor (LT) abgewandt ist (Figur 3).

2. Monolithisch integrierte, aus einem vertikalen MOSFET-Treibertransistor (TT) und einem vertikalen Bipolar-Leistungstransistor (LT) bestehende Darlingtonschaltung, bei der die Drainzone des MOSFET-Treibertransistors (TT) und die Kollektorzone des Bipolar-Leistungstransistors (LT) durch ein gemeinsames Halbleitersubstrat (10) gebildet werden, die Source-Elektrode (18) des MOSFET-Treibertransistors (TT) an die Basiselektrode (19) des Bipolar-Leistungstransistors (LT) angeschlossen ist, der zugleich den Endstufentransistor (ET) der Darlingtonschaltung bildet, wobei der MOSFET-Treibertransistor (TT) und der Bipolar-Leistungstransistor (LT) im lay-out nebeneinander angeordnet sind, insbesondere nach Anspruch 1, dadurch gekennzeichnet, daß im Bipolar-Leistungstransistor (LT) die zur Zuführung seines Basisstroms dienende Basismetallisierung (19) nur in demjenigen Teil seiner Basiswanne (12) angebracht ist, dem der MOSFET-Treibertransistor (TT) benachbart ist (Figur 3).

3. Monolithisch integrierte, aus einem vertikalen MOSFET-Treibertransistor (TT) und einem vertikalen Bipolar-Leistungstransistor (LT) bestehende Darlingtonschaltung, bei der die Drainzone des MOSFET-Treibertransistors (TT) und die Kollektorzone des Bipolar-Leistungstransistors (LT) durch ein gemeinsames Halbleitersubstrat (10) gebildet werden und die Source-Elektrode (18) des MOSFET-Treibertransistors (TT) an die Basiselektrode (19) des Bipolar-Leistungstransistors (LT) angeschlossen ist, wobei der Bipolar-Leistungstransistor (LT) als mindestens zweistufiger Darlington-Tran-sistor ausgebildet ist, dessen letzte Stufe den Endstufentransistor (ET) der Darlingtonschaltung bildet, dadurch

...

gekennzeichnet, daß der MOSFET-Treibertransistor (TT)
und der Bipolar-Endstufentransistor (ET) im lay-out
nebeneinander angeordnet sind, daß der MOSFET-Treibertransistor (TT) eine einzige Kanalzone (17) und eine
einzige Source-Metallisierung (18) enthält, daß die
Kanalzone (17) und die oberhalb dieser Kanalzone (17)
angeordnete Gateelektrode (21) des MOSFET-Treibertransistors (TT) dem Bipolar-Endstufentransistor (ET) zugewandt und die Source-Metallisierung (18) des MOSFET-
Treibertransistors (TT) dem Bipolar-Endstufentransistor
(ET) abgewandt ist (Figur 3).

4. Monolithisch integrierte, aus einem vertikalen
MOSFET-Treibertransistor (TT) und einem vertikalen
Bipolar-Leistungstransistor (LT) bestehende Darlingtonschaltung, bei der die Drainzone des MOSFET-Treibertransistors (TT) und die Kollektorzone des Bipolar-
Leistungstransistors (LT) durch ein gemeinsames Halbleitersubstrat (10) gebildet werden und die Source-
Elektrode (18) des MOSFET-Treibertransistors (TT) an
die Basiselektrode (19) des Bipolar-Leistungstransistors
(LT) angeschlossen ist, wobei der Bipolar-Leistungstransistor (LT) als mindestens zweistufiger Darlingtontransistor ausgebildet ist, dessen letzte Stufe den Endstufentransistor (ET) der Darlingtonschaltung bildet,
insbesondere nach Anspruch 3, dadurch gekennzeichnet,
daß im Bipolar-Endstufentransistor (ET) die zur Zuführung seines Basisstroms dienende Basismetallisierung
(19) nur in demjenigen Teil seiner Basiswanne (12) angebracht ist, dem der MOSFET-Treibertransistor (TT) benachbart
ist (Figur 3).

...

- 4 -

5. Monolithisch integrierte, aus einem vertikalen MOSFET-
Treibertransistor (TT) und einem vertikalen Bipolar-Leistungstransistor (LT) bestehende Darlingtonschaltung, bei der
die Drainzone des MOSFET-Treibertransistors (TT) und die
Kollektorzone des Bipolar-Leistungstransistors (LT) durch
ein gemeinsames Halbleitersubstrat (10) gebildet werden
und die Source-Elektrode des MOSFET-Treibertransistors (TT)
an die Basiselektrode des Bipolar-Leistungstransistors (LT)
angeschlossen ist, dadurch gekennzeichnet, daß der MOSFET-
Treibertransistor (TT) und der Bipolar-Leistungstransistor
(LT) jeweils in eine Vielzahl n streifenförmig ausgebildeter
Teilelemente ($TT_i$, $LT_i$) unterteilt sind (i = 1, 2, 3, ... n)
und daß diese streifenförmig ausgebildeten Teilelemente
($TT_i$, $LT_i$) in dem Halbleitersubstrat (10) periodisch derart aneinandergereiht sind, daß jeweils auf ein Teilelement
($TT_i$) des MOSFET-Treibertransistors (TT) ein Teilelement
($LT_i$) des Bipolar-Leistungstransistors (LT) folgt und
so fort.

6. Darlingtonschaltung nach Anspruch 5, dadurch gekennzeichnet, daß der Bipolar-Leistungstransistor (LT) ein
einziger Transistor ist, der den Endstufentransistor (ET)
der Darlingtonschaltung bildet.

7. Darlingtonschaltung nach Anspruch 5, dadurch gekennzeichnet, daß der Bipolar-Leistungstransistor (LT) aus
einem Endstufentransistor (ET) und aus mindestens einem
dem Endstufentransistor (ET) vorgeschalteten Vortransistor (VT) besteht, die miteinander in Darlingtonschaltung verbunden sind (Fig. 2), und
daß die dem Bipolar-Leistungstransistor (LT) zugeordneten
streifenförmigen Teilelemente ihrerseits jeweils in eine
Anzahl aufeinanderfolgender Teilelemente ($VT_i$, $ET_i$) unter-

...

teilt sind, die der Anzahl der Stufen (VT, ET) entspricht, aus denen der Bipolar-Leistungstransistor
(LT) besteht, wobei innerhalb jeder Periode der streifenförmig ausgebildeten Teilelemente ($TT_i$, $VT_i$, $ET_i$) diese
Teilelemente in der Reihenfolge hintereinander angeordnet sind, in der die ihnen zugeordneten Stufen (TT, VT,
ET) der Darlingtonschaltung im Ersatzschaltbild (Figur 2)
aufeinander folgen.

8. Darlingtonschaltung nach Anspruch 6 oder 7, dadurch
gekennzeichnet, daß die streifenförmig ausgebildeten Teilelemente ($TT_i$) des MOSFET-Treibertransistors (TT) jeweils eine einzige Kanalzone und eine einzige Source-
Metallisierung enthalten und daß die Kanalzone und die
oberhalb der Kanalzone angeordnete Gateelektrode ($G_i$)
dieser Teilelemente jeweils demjenigen unmittelbar benachbarten, streifenförmigen Teilelement ($ET_{i-1}$) des
Endstufentransistors (ET) zugewandt ist, das der vorausgehenden Periode (i - 1) angehört, und daß die Source-Metallisierung jedes Teilelements ($TT_i$) des MOSFET-Treibertran-
sistors (TT) diesem vorausgehenden Teilelement ($ET_{i-1}$)
des Endstufentransistors (ET) abgewandt ist (Figuren 4,
5, 6, 7).

9. Darlingtonschaltung nach einem der Ansprüche 6 bis 8,
dadurch gekennzeichnet, daß in den streifenförmig ausgebildeten Teilelementen ($ET_i$) des Endstufentransistors (ET)
die zur Zuführung ihres Basisstromes dienenden Basismetallisierungen jeweils in demjenigen Teil der Basiswanne angebracht sind, der dem jeweils folgenden, der
nächsten Periode (i + 1) angehörenden streifenförmigen
Teilelement ($TT_{i+1}$) des MOSFET-Treibertransistors (TT)
zugewandt ist (Figuren 4, 5, 6, 7).

FIG. 1

FIG. 2

FIG. 3

FIG. 4

FIG.5

FIG.6

FIG.7